# EUROPEAN PATENT APPLICATION

(11) **EP 2 883 822 A1**
(43) Date of publication of application: **17.06.2015**
(21) Application number: 13828068.0
(22) Date of filing: 22.07.2013
(51) Int. Cl.: B65H 18/08, B65H 20/02, B65H 41/00, C03B 35/00, C23C 14/34

(54) **GLASS FILM CONVEYING DEVICE**

(30) Priority: 07.08.2012 JP 2012174921
(71) Applicant: Kabushiki Kaisha Kobe Seiko Sho (Kobe Steel, Ltd.), Kobe-shi, Hyogo 651-8585 (JP)
(72) Inventor: TAMAGAKI, Hiroshi, Takasago-shi, Hyogo 676-8670 (JP)
(74) Representative: TBK
(86) International application number: PCT/JP2013/004444
(87) International publication number: WO 2014/024398

(57) **Abstract**

A glass film conveying device in which a glass film is properly cooled to suppress breakage when the glass film is placed on a protective film and taken up is provided. A glass film conveying device (100) that continuously conveys a long glass film includes a feeding unit (2) that feeds a glass film from a roll, a glass film conveying unit (3) that conveys the glass film fed from the feeding unit (2), a take-up unit (4) that takes up the glass film conveyed by the glass film conveying unit (3) in a roll shape while laminating the glass film and a protective film R2, and a laminating roller (12) provided in front of the take-up unit (4). A surface temperature of the laminating roller (12) is higher than a temperature of the protective film. The temperature of the protective film is increased, so that evaporation of a volatile component contained in the protective film is promoted. The evaporated volatile component is accumulated between the laminating roller (12) and the protective film and between the protective film and the glass film so as to function as a heat transfer medium and properly lower a temperature of the glass film.

## Description

### TECHNICAL FIELD

The present invention relates to a conveying device of a flexible thin film glass (glass film) capable of being wound in a roll shape in vacuum or under reduced pressure. In particular, the present invention relates to a conveying device that takes up a glass film in a roll shape together with a protective film containing a volatile component such as water content.

### BACKGROUND ART

In recent years, as a substrate material for a display device that displays images or the like, a thin film glass excellent in a gas barrier property, a translucent property, and the like, that is, a glass film is used. Currently, thickness of a general glass film is about 200 pm. However, recently, an extremely thin glass film having thickness of less than 200 µm, which is about 30 pm to 150 pm is developed.

Such an extremely thin glass film has a flexible property due to thinness thereof. Thus, the glass film can be handled as a glass roll in which the glass film is taken up in a roll shape. There is a glass roll in which a resin protective film (such as an interleaf) is sandwiched between adjacent parts of a glass film for the purpose of preventing that a part of the glass film wound in a roll shape is brought into contact with the adjacent parts of the glass film on the inner peripheral side and the outer peripheral side and hence broken.

Patent Document 1 discloses a manufacturing method of a glass roll in which a protective film is sandwiched between adjacent parts of a glass film.

The manufacturing method of the glass roll disclosed in Patent Document 1 is a manufacturing method of a glass roll in which a glass film is formed by the down draw method, and the formed glass film is placed on the protective film and taken up in a roll shape. This manufacturing method is characterized by that while applying larger tension in the conveying direction than that of the glass film to the protective film, the glass film and the protective film are taken up.

As a method of efficiently performing various treatments to such a flexible glass film, a variety of techniques are proposed to perform various treatments such as coating to a surface of a glass film while feeding the glass film from a glass roll in which the long glass film is wound in a roll shape and conveying the glass film by the roll-to-roll process.

As various treatments to be performed to the surface of the glass film, for example, there are treatments performed in a vacuum chamber in which pressure is reduced to almost vacuum such as vacuum vapor deposition and sputtering. In the chamber in which the pressure is reduced to almost vacuum, a variety of influences are generated due to a pressure change. Therefore, in consideration with the generated influences, a variety of techniques are proposed to perform the treatments (surface treatments) such as vacuum vapor deposition and sputtering while conveying the glass film.

Patent Document 2 discloses a thin film glass conveying device that conveys a thin film glass in almost vacuum.

The thin film glass conveying device disclosed in Patent Document 2 is a device including a pressure control means capable of controlling pressure in a vacuum chamber, the device that conveys a long thin film glass in the vacuum chamber in which the pressure is reduced to almost vacuum. In this device, in a state where the roll-shaped thin film glass is arranged in the vacuum chamber, the pressure control means takes three minutes or more to reduce the pressure in the vacuum chamber down to 10,000 Pa and then reduces the pressure to almost vacuum.

In this thin film glass conveying device, after reducing under the above condition, a protective film sandwiched between parts of the thin film glass of the glass roll is removed from the thin film glass at the time of feeding, and at the time of taking up the thin film glass to which a surface treatment is already performed, the protective film is sandwiched between the parts of the thin film glass and the thin film glass is taken up in a roll shape.

However, in vacuum or under reduced pressure, when the resin protective film and the glass film are placed on one another and wound together, by only simply winding and placing on one another, as disclosed in Patent Document 1 and Patent Document 2 described above, the following problems are caused. That is, in a case where a temperature of the glass film is increased (such as 200°C or higher) by a deposition, and when the protective film is brought into contact with the high-temperature glass film, there is a fear that the protective film is damaged to be broken and/or fractured. When the protective film and the glass film are placed on one another and taken up in this state, this triggers undulation or the like of the protective film, and hence there is a fear that the glass film is broken. That is, there is a need for properly cooling the high-temperature glass film at the time of taking up. In particular, in a case where the glass film is treated in a vacuum chamber and the protective film and the glass film are placed on one another and taken up in the chamber, due to vacuum in the chamber, the glass film is not sufficiently cooled and taken up with the temperature of the glass film being still high. In such a case, there is a need for properly cooling the glass film while preventing damage to the protective film.

### CITATION LIST

### PATENT DOCUMENT

Patent Document 1: JP 2011-201765 A
Patent Document 2: JP 2012-1405

### SUMMARY OF THE INVENTION

An object of the present invention is to provide a glass film conveying device capable of placing a glass film and a protective film on one another and taking up while suppressing breakage of the glass film.

A glass film conveying device according to the present invention continuously conveys a long glass film in vacuum or under reduced pressure. This device includes a feeding unit that feeds a glass film from a roll on which the glass film is wound, a glass film conveying unit that conveys the glass film fed by the feeding unit, and a take-up unit that takes up the glass film conveyed by the glass film conveying unit in a roll shape while laminating the glass film and a long protective film having the substantially same width as the glass film and containing a volatile component. The take-up unit increases a temperature of the protective film and thereby vaporizes the volatile component.

### BRIEF DESCRIPTION OF DRAWINGS

[Fig. 1] Fig. 1 is a schematic view showing a configuration of a glass film conveying device according to a first embodiment of the present invention.
[Fig. 2] Fig. 2(A) is a view showing a detail of an A part of Fig. 1, and Fig. 2(B) is a view showing a detail of a B part.
[Fig. 3] Fig. 3 is a schematic view showing a configuration of a glass film conveying device according to a second embodiment of the present invention.
[Fig. 4] Fig. 4 is a schematic view showing a configuration of a glass film conveying device according to a third embodiment of the present invention.

### DESCRIPTION OF EMBODIMENTS

Hereinafter, a glass film conveying device according to embodiments of the present invention will be described with reference to the drawings. It should be noted that in the embodiments and the drawings to be described below, the same constituent members in the glass film conveying device will be given the same reference numerals and the same names. Therefore, regarding the constituent members given the same reference numerals and the same names, the same description will not be repeated.

### [First Embodiment]

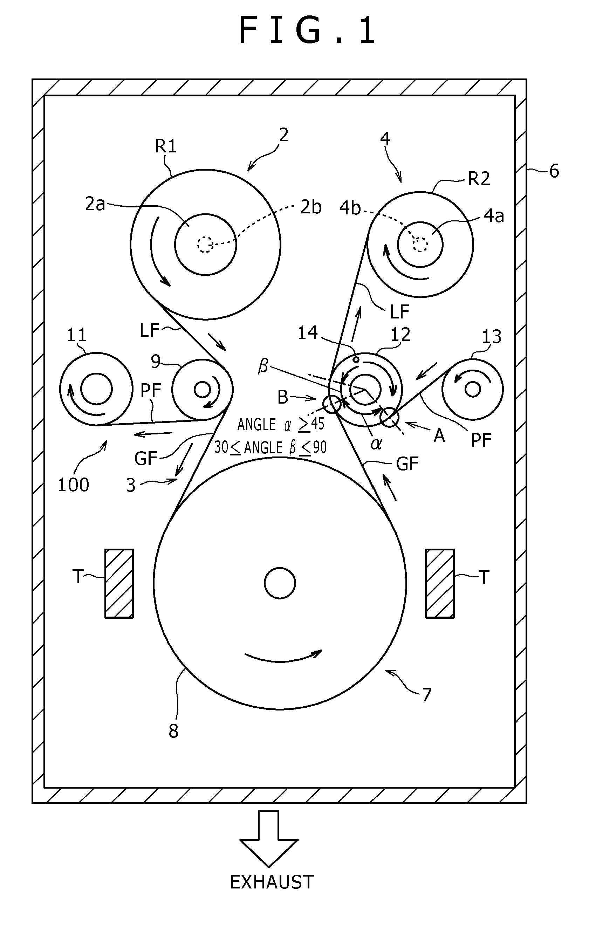

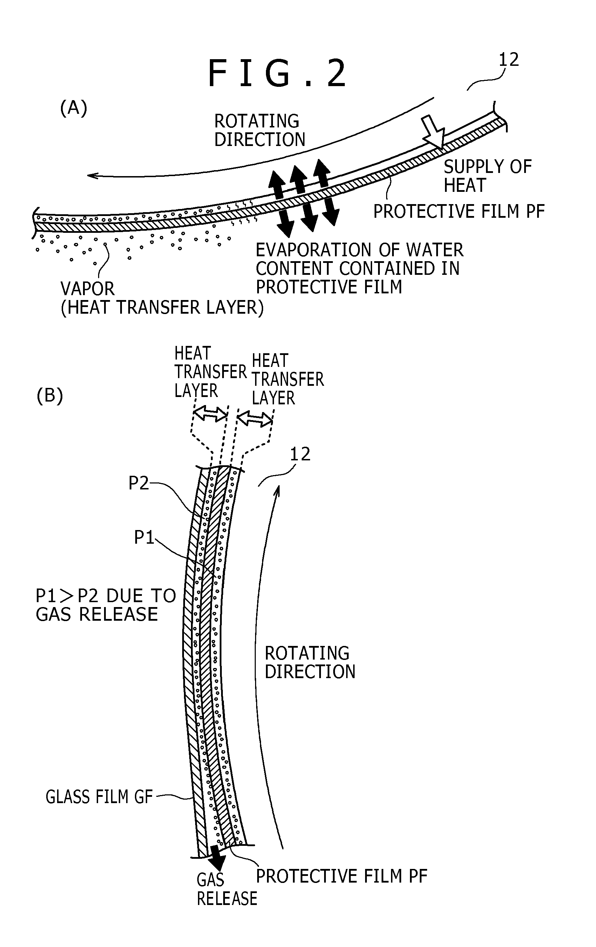

With reference to Figs. 1 and 2, a glass film conveying device 100 according to a first embodiment of the present invention will be described. Fig. 1 is a schematic view showing a configuration of the glass film conveying device 100 according to the first embodiment. Fig. 2(A) is a view showing a detail of an A part of Fig. 1, and Fig. 2(B) is a view showing a detail of a B part of Fig. 1. In this glass film conveying device 100, a pretreatment glass film taken up in a roll shape together with a protective film is separated from the protective film and conveyed, and then taken up in a roll shape together with another protective film.

The glass film conveying device 100 has a feeding unit 2 that feeds a glass film from a glass roll R1 in which a long and band-shaped glass film such as an extremely thin glass film having width of about one meter and thickness of about 30 µm to 200 µm is wound in a roll shape, a glass film conveying unit 3 that conveys the fed glass film to a surface treatment step for performing a surface treatment under reduced pressure or in vacuum such as sputtering, plasma CVD, vapor deposition, ion plating, AIP method, plasma irradiation treatment, and ion implantation, and a take-up unit 4 that takes up the glass film to which the surface treatment is already performed as a roll-shaped glass roll R2 again. The glass film conveying device 100 is a device that feeds the glass film from the glass roll R1 in which for example the long glass film of 100 m or more is wound in a roll shape and conveys the glass film by the so-called roll-to-roll process.

Specifically, in the glass roll R1, on one surface of a glass film GF, a resin protective film PF formed to have the substantially same width as that of the glass film GF is placed and laminated. Thickness of the protective film PF is about the same as that of the glass film GF. However, as long as the protective film is thick enough to protect the glass film from breakage or damage, the thickness is not required to be about the same as that of the glass film GF.

A laminated film LF made as a double layer by placing the glass film GF and the protective film PF on one another in such a way is wound on a feeding core 2a of the feeding unit 2 to be described later so as to serve as the glass roll R1. The feeding core 2a is made of a stainless material for example. The glass roll R1 is preferably wound in such a manner that a part of the laminated film LF on the side of the protective film PF is in contact with a winding core of the feeding core 2a at the beginning of winding. The roll is formed in such a manner that the protective film PF and the glass film GF are alternately placed on one another from the winding core of the feeding core 2a toward the outer peripheral side.

At the time of feeding the glass film GF from the feeding unit 2, there are a method of firstly feeding the laminated film LF and separating the fed laminated film LF into the glass film GF and the protective film PF, and a method of feeding the glass film GF on the outer peripheral side among the laminated film LF at first and then feeding the protective film PF, that is, alternately feeding the glass film GF and the protective film PF.

With reference to Fig. 1, the configuration of the glass film conveying device 100 according to the first embodiment will be described.

In the following description, the up and down direction with respect to the paper plane of Fig. 1 indicates the up and down direction of the glass film GF conveying device 100, and similarly, the left and right direction with respect to the paper plane indicates the left and right direction of the glass film conveying device 100.

As described above, the glass film conveying device 100 includes the feeding unit 2 that feeds the glass film GF from the glass roll R1, the glass film conveying unit 3 that conveys the fed glass film GF to the surface treatment step, and the take-up unit 4 that takes up the glass film GF to which the surface treatment is already performed in a roll shape again.

The glass film conveying device 100 with such a configuration is provided in a box-shaped vacuum chamber 6 for example.

The vacuum chamber 6 is formed in a casing whose inside is hollow to be maintained airtight with respect to an exterior. Although not shown in the figure, a vacuum pump is provided on the lower side of the vacuum chamber 6. By this vacuum pump, pressure is reduced to a vacuum state or a low pressure state inside the vacuum chamber 6.

The feeding unit 2 includes the feeding core 2a, a rotation shaft 2b coupled to the feeding core 2a, a protective film separating roller 9 that separates the protective film PF from the laminated film LF fed from the glass roll R1, and a protective film take-up roll 11 that takes up the separated protective film PF.

The feeding core 2a of the feeding unit 2 is arranged on the left upper side of a center part in the up and down direction in the vacuum chamber 6 shown in Fig. 1. The feeding core 2a includes the cylindrical or columnar winding core whose total length is slightly longer than width of the laminated film LF. One surface of disk-shaped flanges may be coaxially fixed to both ends of this winding core. In the feeding core 2a with such a configuration, by winding the laminated film LF in which the glass film GF and the protective film PF are laminated on the winding core of the feeding core 2a, the glass roll R1 is formed.

The rotation shaft 2b of the feeding unit 2 is arranged in the vacuum chamber 6 so as to be placed in the perpendicular direction with respect to the paper plane of Fig. 1. The rotation shaft 2b is coupled to the feeding core 2a. In this feeding unit 2, by rotating the rotation shaft 2b and the feeding core 2a coupled to the rotation shaft, the laminated film LF (that is, the glass film GF and the protective film PF) can be fed from the glass roll R1.

On the lower side of the center in the up and down direction in the vacuum chamber 6 shown in Fig. 1, on the lower side of the feeding unit 2, a deposition device that performs the surface treatment step such as sputtering and plasma CVD to a surface of the glass film GF fed from the feeding unit 2 and separated from the protective film PF is provided. In the first embodiment, a sputter deposition unit 7 is provided as one example.

The glass film conveying unit 3 includes a conveying member of the glass film GF in the sputter deposition unit 7 that performs this surface treatment step. Fig. 1 shows a deposition roll 8 and targets T serving as part of a configuration of the general sputter deposition unit 7.

The deposition roll 8 of the sputter deposition unit 7 shown in Fig. 1 is a conveying member made of a stainless material or the like and formed in a cylindrical or columnar shape, the conveying member in which the glass film GF is wound around an outer peripheral surface forming a curved surface and conveyed. The deposition roll 8 is arranged in such a manner that an axis center of the deposition roll 8 serving as a rotation center (rotation shaft) is substantially parallel to an axis center of the feeding unit 2 serving as a rotation center (that is, an axis center of the winding core of the feeding core).

The sputter evaporation sources T are arranged on the left and right sides of the deposition roll 8 so as to face the glass film GF conveyed by the deposition roll 8. The sputter evaporation sources T are evaporation sources formed by a component to be deposited on the surface of the glass film GF, the component sputtered (evaporated) by glow discharge as already known is guided to and deposited on the surface of the glass film GF.

As described above, the deposition roll 8 forms the glass film conveying unit 3 for conveying the glass film GF fed from the feeding unit 2 in order to perform the surface treatment step. It should be noted that a temperature of the deposition roll 8 is a high temperature of 200°C to 400°C for example.

In the first embodiment, as shown in Fig. 1, the protective film separating roller 9 of the feeding unit 2 is arranged between the feeding core 2a and the deposition roll 8. The protective film separating roller 9 is a member made of a stainless material or the like and formed in a cylindrical or columnar shape as well as the deposition roll 8. However, an outer diameter of the cylindrical or columnar shape is smaller than an outer diameter of the deposition roll 8.

A rotation shaft of the protective film separating roller 9 is parallel to the rotation shafts of the feeding core 2a and the deposition roll 8, and furthermore, in the left and right direction of the vacuum chamber 6, arranged closer to the center of the vacuum chamber 6 than a left end of the deposition roll 8, that is, close to the rotation shaft of the deposition roll 8. This arrangement of the protective film separating roller 9 enables the glass film GF to be always conveyed to the deposition roll 8 by the fixed angle in the fixed direction.

This protective film separating roller 9 separates the glass film GF and the protective film PF forming the laminated film LF. After separation, the protective film PF is taken up by the protective film take-up roll 11, and the glass film GF is conveyed to the deposition roll 8.

Since the feeding unit 2 includes the protective film separating roller 9 and the protective film take-up roll 11, the protective film PF among the laminated film LF fed from the glass roll R1 can be separated from the glass film GF and collected.

In the vacuum chamber 6 shown in Fig. 1, the take-up unit 4 is arranged on the right side of the feeding unit 2 with respect to the paper plane of Fig. 1. The take-up unit 4 takes up the glass film GF to which the surface treatment is performed through the glass film conveying unit 3 as the roll-shaped glass roll R2 again.

The take-up unit 4 includes a take-up core 4a, a rotation shaft 4b coupled to the take-up core 4a, a laminating roller 12 that laminates the glass film GF and a protective film PF, a protective film roll 13 that supplies the new protective film PF to the laminating roller 12, and a heating mechanism 14 that heats the laminating roller 12. The laminating roller 12 is provided on the upstream side of the take-up core 4a in the conveying direction of the glass film GF.

The take-up core 4a of the take-up unit 4 has the same configuration as the above feeding core 2a, and hence has a cylindrical or columnar winding core whose total length is slightly longer than width of the laminated film LF. The rotation shaft 4b of the take-up unit 4 is arranged in the vacuum chamber 6 in parallel to the above rotation shafts of the feeding unit 2, the deposition roll 8, and the like so as to be placed in the perpendicular direction with respect to the paper plane of Fig. 1.

In this take-up unit 4, by rotating the rotation shaft 4b and the take-up core 4a coupled to the rotation shaft by an actuator or the like, the new protective film PF supplied from the protective film roll 13 is taken up, and all together, the glass film GF conveyed from the glass film conveying unit 3 is taken up.

As shown in Fig. 1, the laminating roller 12 is arranged between the take-up core 4a and the deposition roll 8 on the right side of the protective film separating roller 9.

This laminating roller 12 is a member made of a stainless material or the like and formed in a cylindrical or columnar shape as well as the deposition roll 8 with the same configuration as the protective film separating roller 9. A rotation shaft of the laminating roller 12 is parallel to the rotation shafts of the take-up unit 4 and the deposition roll 8, and furthermore, in the left and right direction of the vacuum chamber 6, arranged closer to the center of the vacuum chamber 6 than a right end of the deposition roll 8, that is, close to the rotation shaft of the deposition roll 8. This arrangement of the laminating roller 12 enables the glass film GF to be always carried out from the deposition roll 8 by the fixed angle along the fixed direction.

Hereinafter, this laminating roller 12 will be described in detail.

A diameter of this laminating roller 12 is Φ100 mm to Φ300 mm, preferably Φ125 mm to Φ200 mm.

When being supplied onto the laminating roller 12, the protective film PF is preferably supplied by tension within a range of 50 N/m to 200 N/m. Meanwhile, the glass film GF is preferably supplied by weaker tension than the tension of the protective film PF. The tension Tf of the protective film PF is preferably about twice more than the tension Tg of the glass film GF or more. In other words, in the laminating roller 12, the tension in the conveying direction applied to the protective film PF is preferably set to be larger than the tension in the conveying direction applied to the glass film GF so that a close attachment degree of the protective film PF to the laminating roller 12 can be enhanced and evaporation of water content contained in the protective film PF can be promoted.

Preferably, the protective film PF is closely attached onto the laminating roller 12 in a range of an angle α = 45° or more, and the glass film GF is further placed on the protective film PF. Further, continuously to the range of the angle α, in a range of an angle β = 30° to 90° (over 90° is acceptable if not excessive) and length of 50 mm or more, the glass film GF is brought into contact with the protective film PF, and then, the glass film GF and the protective film PF are alienated from the laminating roller 12 in a state where the glass film and the protective film are in contact with each other. After that, the laminated film LF in which the glass film GF and the protective film PF are laminated is taken up in a roll shape by the take-up core 4a of the take-up unit 4. When the laminated film LF in which the glass film GF and the protective film PF are laminated is taken up in a roll shape by the take-up core 4a, the laminated film is preferably taken up with the protective film PF being placed on the inner side.

A temperature of the laminating roller 12 is a higher temperature than that of the protective film PF, preferably set to 40 to 80°C. This laminating roller 12 is heated by the heating mechanism 14 so that a surface temperature of the laminating roller 12 becomes higher than the temperature of the protective film PF. Thereby, the temperature of the protective film PF can be increased, so that the evaporation of water content contained in the protective film PF can be promoted. The heating mechanism 14 is a mechanism that heats the laminating roller 12 by circulating hot water inside the laminating roller 12 for example. It should be noted that the heating mechanism 14 is schematically shown in the figure.

The increase of the temperature indicates to increase the temperature to be higher than a temperature of the protective film PF in a normal state by external heating. Regarding the protective film PF under a vacuum/low pressure environment, water content contained in the protective film PF is evaporated even in a normal state. In the present invention, it is important to promote the evaporation of water content more than the normal state where no external heating is performed by increasing the temperature of the protective film PF. In the above description, 40 to 80°C is shown as an example of the external temperature. However, the present invention is not limited to this but the temperature is changed depending on a material of the protective film PF or a degree of vacuum, and can be properly set by those skilled in the art.

The material of the protective film PF will be described. For the protective film PF, a material having a relatively high water absorption rate of 0.2% or more, the material that moderately emits vapor such as PET, PC (polycarbonate), PES, and PI (polyimide) is more preferable than a film having a low water absorption rate of less than 0.01%, the film that emits little vapor such as COP. In particular, due to a need for promptly emitting vapor from the surface, a material having a vapor permeation coefficient exceeding 10 g/m²/day on the premise of thickness of 100 pm is preferable. Paper can also be used as the protective film PF. Although water content is contained inside the protective film PF in the above description, water content adhering onto the surface is also included. In the present embodiment, water content is shown as an example. However, the present invention is not limited to this but may be applied to any volatile component other than water content contained in the protective film PF to be evaporated by heating in vacuum or under reduced pressure, the volatile component that causes less contamination in the vacuum chamber.

With such a configuration, a state in the vicinity of the surface of the laminating roller 12 when the glass film GF is placed on the protective film PF in the laminating roller 12 and taken up by the take-up core 4a of the take-up unit 4 will be described with reference to Fig. 2.

As shown in the A part of Fig. 1 and Fig. 2(A), the protective film PF is firstly taken up by the laminating roller 12. This protective film PF is a new protective film PF supplied from the protective film roll 13 and has an about normal temperature. Meanwhile, the surface temperature of the laminating roller 12 is 40°C to 80°C which is higher than this temperature of the protective film PF, and the tension in the take-up direction of the protective film PF is larger than the tension of the glass film GF. Therefore, the protective film PF is closely attached to the laminating roller 12, and heat is supplied from the surface of the laminating roller 12 having a higher temperature than the temperature of the protective film PF.

When heat is supplied to the protective film PF in such a way, emission of water content from the resin protective film PF containing water content is promoted. Vapor emitted in such a way forms heat transfer layers in a gap between the laminating roller 12 and the protective film PF and on the outer peripheral side of the protective film PF.

In order to provide route length by which such a state is sufficiently formed, the above angle α (angle with which only the protective film PF is in contact with the laminating roller 12) and the angle β (angle with which the protective film PF and the glass film GF are in contact with the laminating roller 12) are set.

As shown in Fig. 1, the angle α and the angle β are angles around the rotation center of the laminating roller 12. The angle α is an angle made by a line connecting a position where take-up of the protective film PF is started on the laminating roller 12 and the rotation center of the laminating roller 12, and a line connecting a position where take-up of the glass film GF is started and the rotation center of the laminating roller 12. The angle β is an angle made by the line connecting the position where the take-up of the glass film GF is started on the laminating roller 12 and the rotation center of the laminating roller 12, and a line connecting a position where the laminated film LF serving as a laminated body of the glass film GF and the protective film PF is alienated from the laminating roller 12 and the rotation center of the laminating roller 12.

Next, as shown in the B part of Fig. 1 and Fig. 2(B), the glass film GF is wound and placed on the laminating roller 12. In this state, heat is sufficiently supplied from the laminating roller 12 to the protective film PF while the laminating roller 12 is rotated by the angle α, and the surface temperature of the laminating roller 12 and the temperature of the protective film PF become substantially equal. Meanwhile, in this state, the surface temperature of the laminating roller 12 and the temperature of the protective film PF which are substantially equal are lower than the temperature of the glass film GF.

When the high-temperature glass film GF is brought into contact with the protective film PF, heat transfer between the glass film GF and the protective film PF and heat transfer between the protective film PF and the laminating roller 12 are promoted (to a great extent in comparison to a vacuum state in the vacuum chamber 6) by the emitted gas (vapor). Therefore, the temperature of the high-temperature glass film GF is properly cooled. That is, in a state where the gas emitted from the protective film PF is accumulated between the glass film GF and the protective film PF and between the protective film PF and the laminating roller 12, the glass film GF is brought into contact with the protective film PF. Thus, heat transfer from the glass film GF to the laminating roller 12 via the protective film PF is accelerated, so that the glass film GF is properly cooled.

When the glass film GF is placed on the protective film PF in such a way, the gas emitted to the outer side of the protective film PF is accumulated between the glass film GF and the protective film PF, so as to promote the heat transfer between the glass film GF and the protective film PF.

The heat of the glass film GF is transferred to the protective film PF. However, the gas is accumulated between the protective film PF and the laminating roller 12, so as to promote the heat transfer between both the protective film and the laminating roller.

At this time, the gas accumulated between the glass film GF and the protective film PF (pressure P2) is released as a lower side part is opened. However, the gas accumulated between the protective film PF and the laminating roller 12 (pressure P1) is not released as a lower side part is not opened. Thus, P1 > P2 is established. Since pressure P of the gas serving as a heat transfer medium is different in such a way, a heat transfer coefficient from the protective film PF to the laminating roller 12 is higher than a heat transfer coefficient from the glass film GF to the protective film PF. Therefore, the temperature of the protective film PF does not become high and the glass film GF is properly cooled, so that the protective film PF is not exposed to a high temperature and the protective film PF is protected from damage.

It should be noted that in a case where emission of the gas from the side of the laminating roller 12 of the protective film PF is relatively large due to a difference in a coating layer or the like between two sides of the protective film PF, it is preferable in a point that the temperature can be stably controlled.

Next, with reference to Fig. 1, actions of the glass film conveying device 100 will be described. Hereinafter, description of preparative operations for activating the glass film conveying device 100 such as carrying the glass roll R1 into the glass film conveying device 100 and winding the protective film PF and the glass film GF on the rollers will be omitted.

Firstly, the glass film GF serving as one film of the laminated film LF is fed from the glass roll R1 attached to the rotation shaft 2b of the feeding unit 2, and conveyed to the glass film conveying unit 3. At this time, by the protective film separating roller 9 of the feeding unit 2, the protective film PF is separated from the glass film GF in a state where the glass film GF and the protective film PF are placed on one another, and the protective film PF is taken up by the protective film take-up roll 11. Together with this, the glass film GF is conveyed to the deposition roll 8.

In a state where the glass film GF conveyed to the deposition roll 8 is wound on the deposition roll 8, the surface treatment is performed by performing a sputter treatment.

The glass film GF to which the surface treatment is performed is conveyed from the deposition roll 8 to the laminating roller 12 of the take-up unit 4, and conveyed from the laminating roller 12 to the take-up core 4a. By this laminating roller 12, the new protective film PF and the glass film GF after the treatment are placed on one another. At this time, the surface temperature of the laminating roller 12 is set to be 40°C to 80°C, and the take-up tension of the protective film PF is set to be stronger than the take-up tension of the glass film GF. Heat is supplied from the laminating roller 12 to the protective film PF firmly and closely attached to the laminating roller 12, and emission of contained water content from the protective film PF (vaporization and gasification of contained water content) is promoted.

The gas emitted from the protective film PF is accumulated between the glass film GF and the protective film PF. The heat transfer between the glass film GF and the protective film PF is promoted, and the heat of the glass film GF is transferred to the protective film PF. Further, the gas is also accumulated between the protective film PF and the laminating roller 12. The heat transfer between the protective film PF and the laminating roller 12 is more largely promoted, and the heat transferred from the glass film GF to the protective film PF is sufficiently transferred from the protective film PF to the laminating roller 12. As a result, the temperature of the protective film PF does not become high and the glass film GF is properly cooled. As a result, the protective film PF is not exposed to a high temperature, and the protective film PF is protected from damage.

In this case, when the diameter of the laminating roller 12 is 100 mm or less, the glass film GF is bent too much, so that a possibility of breakage is increased. In order to provide the heating mechanism 14 in the laminating roller 12, the diameter is required to be about Φ100 mm. When the diameter of the laminating roller 12 is uselessly large, this glass film conveying device 100 is uselessly enlarged. It is not realistic that the diameter of the laminating roller 12 exceeds Φ300 mm. The most preferable range of the diameter of the laminating roller 12 is Φ125 to 200 mm. Under the condition that the diameter of the laminating roller 12 is Φ125 mm, when the protective film PF is wound within the range of 45°, length of a contact surface between the protective film PF and the laminating roller 12 is about 50 mm or more, so that the protective film is brought into contact with the glass film GF in a sufficiently thermally stable state. Under the condition that the diameter of the laminating roller 12 is Φ200 mm or less, it is advantageous with a view of downsizing of the glass film conveying device 100. Further, a small diameter of the laminating roller 12 is also advantageous with a view of a more stabilized close attachment state between the protective film PF and the laminating roller 12.

In a case where the glass film GF is placed on the protective film immediately after the protective film PF is wound on the laminating roller 12, the glass film GF is placed on the protective film in a state where undulation of the protective film PF is not sufficiently settled. Thus, a possibility that the glass film GF is broken is increased. According to knowledge of the inventor of this application, on the laminating roller 12 satisfying the requirement of the diameter of the laminating roller 12, undulation and wrinkles of the protective film PF are completely eliminated by winding in the range of 45° or more.

In particular, in order to prevent damage to the protective film PF, close attachment between the protective film PF and the laminating roller 12 is desirably stronger than close attachment between the glass film GF and the protective film PF. The protective film PF is supplied preferably by the take-up tension of 50 N/m or more. Conversely, the tension of the glass film GF is preferably sufficiently weaker than the tension of the protective film PF. For this, the tension of the protective film PF is desirably stronger than the tension of the glass film GF. More preferably, the tension of the protective film PF is desirably about twice more than the tension of the glass film GF or more.

The glass film GF is wound on the protective film PF flattened on the laminating roller 12. For carrying out in a state where the glass film GF and the protective film PF are stably placed on one another, there is a need for placing and winding by a winding angle with the angle β of 30° or more. Meanwhile, by winding angle with the angle β excessively exceeding 90°, a possibility of breakage is increased.

The laminated film LF in which the protective film PF and the glass film GF are placed on one another is preferably taken up in a roll shape with the side of the protective film PF being placed on the inner side.

In particular, the temperature of the laminating roller 12 is set to be higher than the temperature of the protective film PF. Thus, from a time point when the protective film PF is brought into contact with the laminating roller 12, the emission of the gas such as vapor from the protective film PF is started, so that heat exchange between the protective film PF and the laminating roller 12 is promoted, and the emitted gas facilitates slip between the protective film PF and the laminating roller 12 and also promotes close attachment.

As described above, in the glass film conveying device according to the first embodiment, by promoting the emission of water content contained in the resin protective film PF and making the emitted gas function as the heat transfer medium, the temperature of the protective film PF does not become high and the high-temperature glass film GF can be properly cooled. When the temperature of the glass film GF is not high, the situation where the protective film PF is damaged to be broken and/or fractured can be avoided. Therefore, even when the protective film PF and the glass film GF are placed on one another and taken up, there is no fear that the glass film GF is broken. Thus, in the glass film conveying device according to the first embodiment, while suppressing breakage of the glass film GF, the glass film GF and the protective film PF can be placed on one another and taken up.

The above method of controlling the temperature of the glass film GF can also be applied to a case where the glass film GF is cooled to a remarkably low temperature by a treatment in vacuum. That is, when the glass film GF is brought into contact with the protective film PF in a state where the glass film is cooled to an extremely low temperature such as -100°C, the protective film PF is cooled, suppleness of the protective film PF is lost, and as a result, damage such as fracture of the protective film PF is generated, and further, there is a fear that breakage of the glass film GF is caused. In such a case, by applying the above configuration of the first embodiment, when brought into contact with the protective film PF heated by contact with the laminating roller, the glass film GF can be similarly heated via vapor so as to have a proper temperature for take-up. Thus, while suppressing breakage of the protective film PF and the glass film, the protective film and the glass film can be placed on one another and taken up.

### [Second Embodiment]

Hereinafter, a glass film conveying device 200 according to a second embodiment of the present invention will be described. It should be noted that in the glass film conveying device 200 according to the second embodiment, the same configurations as the above glass film conveying device 100 according to the first embodiment will be given the same reference numerals. Functions of those are the same. Therefore, detailed description of those will not be repeated.

In the above glass film conveying device 100, the glass roll R1 in which the glass film GF is taken up in a roll shape together with the protective film PF by the feeding core 2a of the feeding unit 2 is used. Thus, the feeding unit 2 includes the protective film separating roller 9 and the protective film take-up roll 11.

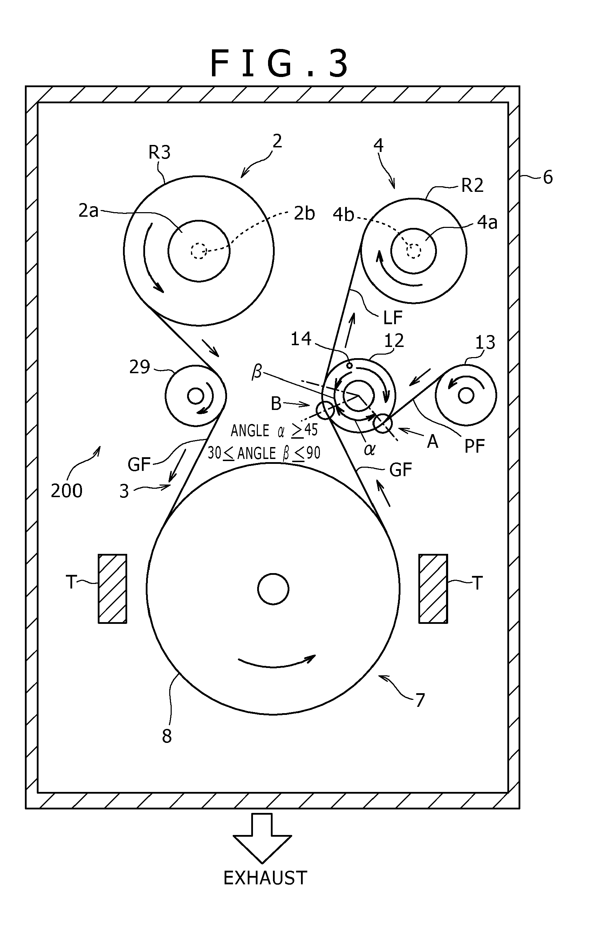

Fig. 3 shows a schematic view of a configuration of the glass film conveying device 200 according to the second embodiment. In this glass film conveying device 200, a glass roll R3 in which only the glass film GF is taken up in a roll shape without take-up of the protective film PF is attached to the rotation shaft 2b of the feeding unit 2. Therefore, as shown in Fig. 3, the glass film conveying device 200 does not include the protective film separating roller 9 and the protective film take-up roll 11. However, in order to ensure the contact angle of the glass film GF in the deposition roll 8, a roller 29 similar to the protective film separating roller 9 is provided at the position of the protective film separating roller 9.

The other configurations of this glass film conveying device 200 are the same as the configurations of the glass film conveying device 100.

In the glass film conveying device 200 according to the second embodiment, as well as the glass film conveying device 100 according to the first embodiment, even when the glass roll R3 attached to the rotation shaft 2b of the feeding unit 2 is a roll only with the glass film GF, while suppressing breakage of the glass film GF, the glass film GF and the protective film PF can be placed on one another and taken up.

In particular, the second embodiment is preferably applied to the glass roll R3 in which protective tape materials (so-called edge tabs) are attached to both ends in the width direction of the glass film GF (that is, both ends divided in the perpendicular direction with respect to the paper plane of Fig. 2). In this case, width of the protective film PF being about the same as or slightly narrower than width of a region between the protective tape materials of the glass film GF and thickness of the protective film PF being greater than thickness of the protective tape materials are preferable with a view of temperature control of the glass film GF and take-up.

### [Third Embodiment]

Hereinafter, a glass film conveying device 300 according to a third embodiment of the present invention will be described. It should be noted that in the glass film conveying device 300 according to the third embodiment, the same configurations as the above glass film conveying device 100 according to the first embodiment will be given the same reference numerals. Functions of those are the same. Therefore, detailed description of those will not be repeated.

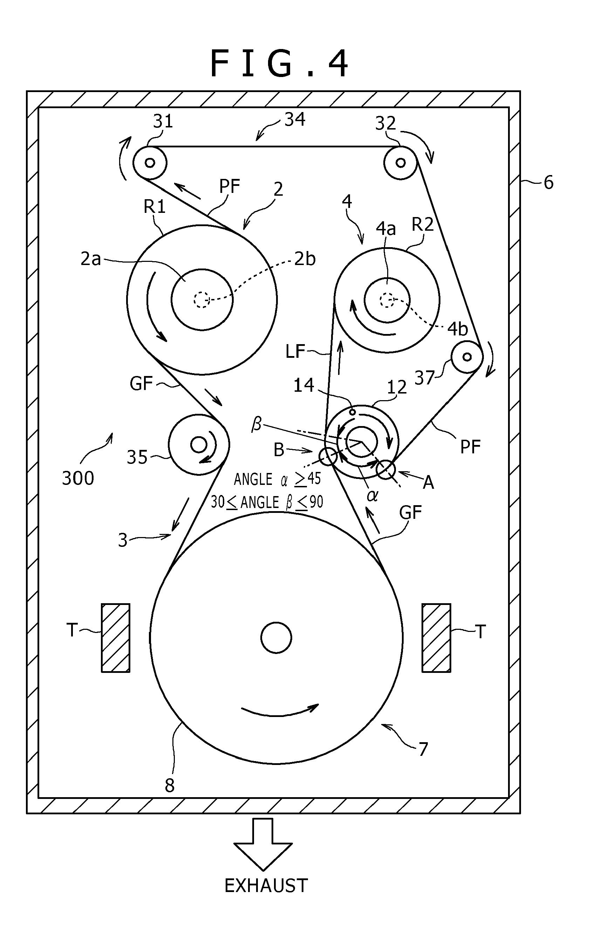

Fig. 4 shows a schematic view of a configuration of the glass film conveying device 300 according to the third embodiment. In this glass film conveying device 300, the protective film PF alienated from the glass film GF in the feeding core 2a of the feeding unit 2 is re-used in the take-up unit 4. Therefore, as shown in Fig. 4, this glass film conveying device 300 includes a protective film conveying unit 34. In order to ensure the contact angle of the glass film GF in the deposition roll 8, this glass film conveying device 300 includes a first guide roller 35. Further, for the laminating roller 12 to satisfy the above angle α and the angle β, a second guide roller 37 is provided at a desired position, and positions of the take-up core 4a of the take-up unit 4 and the laminating roller 12 are set.

The take-up core 4a and the rotation shaft 4b of the take-up unit 4 and the laminating roller 12 in this glass film conveying device 300 respectively have the same configurations as the take-up core 4a and the rotation shaft 4b of the take-up unit 4 and the laminating roller 12 in the above glass film conveying device 100. Therefore, the laminating roller 12 in this glass film conveying device 300 satisfies all the temperature conditions, the angle conditions, and the roller diameter conditions in the laminating roller 12 in the glass film conveying device 100. In particular, there is no interference between the protective film conveying unit 34 and the glass roll R2 including the take-up core 4a of the take-up unit 4, and in order to satisfy the angle α ≥ 45°, the second guide roller 37 is provided.

The glass film conveying device 300 includes the protective film conveying unit 34 that carries out the protective film PF separated from the glass film GF which is fed from the feeding unit 2 and carries in the protective film PF toward the take-up core 4a of the take-up unit 4.

As shown in Fig. 4, the protective film conveying unit 34 has a first protective film roller 31 arranged on the upper side of the feeding unit 2, and a second protective film roller 32 arranged on the upper side of the take-up unit 4.

The first protective film roller 31 and the second protective film roller 32 are cylindrical or columnar rollers having the substantially same configurations as the first guide roller 35. In the third embodiment, outer diameters of the first protective film roller 31 and the second protective film roller 32 are slightly smaller than an outer diameter of the first guide roller 35. Each of such first and second protective film rollers 31 and 32 is arranged in the vicinity of a part immediately above the feeding core 2a of the feeding unit 2 or the take-up core 4a of the take-up unit 4 in such a manner that rotation shafts of the rollers 31, 32 are substantially parallel to the rotation shafts 2b, 4b of the feeding core 2a and the take-up core 4a.

The glass film GF to which the surface treatment is performed in the sputter deposition unit 7 is conveyed to the take-up unit 4. Specifically, the glass film GF is conveyed to the take-up core 4a from the deposition roll 8 via the laminating roller 12.

At the same time as this conveyance of the glass film GF, the protective film PF is conveyed to the protective film conveying unit 34, passes from the first protective film roller 31 through to the second protective film roller 32, and is conveyed to the laminating roller 12 via the second guide roller 37.

As shown in Fig. 4, the protective film PF passing through the second protective film roller 32 is wound on the laminating roller 12. In the laminating roller 12, after the protective film PF is wound and then rotated by the angle α of 45° or more as well as the first embodiment, the glass film GF conveyed form the deposition roll 8 is taken up onto the protective film PF wound in advance. The laminated film LF in which the glass film GF and the protective film PF are placed on one another is rotated by the angle β (30° ≤ β ≤ 90°). After that, the laminated film LF is conveyed to the take-up core 4a and wound on the take-up core 4a, so that the glass roll R2 is formed.

In such a way, in this glass film conveying device 300, as well as the above glass film conveying device 100 except the point that the protective film PF is re-used, by increasing the temperature of the protective film PF by the laminating roller 12, the emission of water content contained in the protective film PF (vaporization and gasification of contained water content) is promoted.

It should be noted that since the protective film PF is re-used in this glass film conveying device 300, there is sometimes a case where water content contained in the protective film PF is not easily emitted as vapor (gas). In this case, by adjusting the position of the second guide roller 37 or the like so as to change the angle α and/or the angle β within the above angle range, the emission of desired water content from the protective film PF as vapor (gas) may be promoted. By setting the temperature of the laminating roller 12 to be further high, the emission of water content from the protective film PF may be promoted.

As described above, with the glass film GF conveying device according to the third embodiment, while suppressing breakage of the glass film GF, the glass film GF and the protective film PF can be placed on one another and taken up.

### [Modified Example]

Hereinafter, a glass film conveying device according a modified example of the present invention will be described. This modified example can be applied to the above first to third embodiments.

In the present modified example, a point that the temperature of the protective film is increased so as to promote the evaporation of contained water content and the evaporated gas serves as the heat transfer medium is the same as the above embodiments. In the above embodiments, in order to increase the temperature of the protective film, the temperature of the laminating roller is controlled and set to be 40°C to 80°C which is higher than the temperature of the protective film. However, the present invention is not limited to this. The present modified example is different in a point that the temperature of the protective film is increased not by the laminating roller whose temperature is adjusted but by the glass film itself. Therefore, the temperature of the laminating roller is not required to be actively increased but may be about 20°C lower than a room temperature (or a normal temperature).

That is, in a case where the temperature of the glass film when brought into contact with the protective film is a high temperature, the temperature of the protective film is not increased by the laminating roller but the heat from the high-temperature glass film is applied to the protective film and the temperature of the protective film is increased. Thereby, a situation where water content contained in the protective film is emitted as vapor (gas) is promoted, and the gas is accumulated between the glass film and the protective film and between the protective film and the laminating roller, so that the heat transfer between those can be promoted. It should be noted that the temperature of the laminating roller may be a lower temperature than that of the protective film as long as angle conditions and laminating roller diameter conditions other than the temperature conditions are met.

As described above, with the glass film conveying device according to the modified example of the present invention, the temperature of the protective film is increased not by the laminating roller but by the high-temperature glass film. Thus, without controlling the temperature of the laminating roller, the glass film and the protective film can be placed on one another and taken up while suppressing breakage of the glass film.

It should be noted that the specific embodiments described above mainly include the inventions with the following configurations.

A glass film conveying device according to the present invention continuously conveys a long glass film in vacuum or under reduced pressure. This device includes a feeding unit that feeds a glass film from a roll on which the glass film is wound, a glass film conveying unit that conveys the glass film fed by the feeding unit, and a take-up unit that takes up the glass film conveyed by the glass film conveying unit in a roll shape while laminating the glass film and a long protective film having the substantially same width as the glass film and containing a volatile component. The take-up unit increases a temperature of the protective film and thereby vaporizes the volatile component.

Preferably, the take-up unit can include a laminating roller that laminates the glass film and the protective film, and a heating mechanism that heats the laminating roller in such a manner that a surface temperature of the laminating roller becomes a higher temperature than the temperature of the protective film.

Further preferably, the take-up unit can include a laminating roller that laminates the glass film and the protective film, and increase the temperature of the protective film by abutting the glass film having a higher temperature than the protective film with the protective film in the laminating roller.

Further preferably, the take-up unit can include a laminating roller that laminates the glass film and the protective film, and tension in the conveying direction applied to the protective film can be larger than tension in the conveying direction applied to the glass film in the laminating roller.

Further preferably, the take-up unit can include a laminating roller that laminates the glass film and the protective film, and the glass film can be laminated on the protective film in a rotation range of 45 degrees or more from a position where take-up of the protective film on the laminating roller is started.

Further preferably, the feeding unit can separate the protective film from the roll on which the glass film is wound in a state where the glass film and the long protective film having the substantially same width as the glass film are laminated, and feed the glass film.

Further preferably, the glass film conveying unit can convey the glass film fed from the feeding unit and separated from the protective film, and the take-up unit can take up the glass film conveyed by the glass film conveying unit in a roll shape while laminating the glass film and the protective film separated from the glass film in the feeding unit and conveyed to the take-up unit.

Further preferably, the volatile component may include water content.

### EXPLANATION OF REFERENCE NUMERALS

- 100, 200, 300:: Glass film conveying device
- 2:: Feeding unit
- 3:: Glass film conveying unit
- 4:: Take-up unit
- 6:: Vacuum chamber
- 7:: Sputter deposition unit
- 8:: Deposition roll
- 9:: Protective film separating roller
- 11:: Protective film take-up roll
- 12:: Laminating roller
- 13:: Protective film roll
- 14:: Heating mechanism
- GF:: Glass film
- LF:: Laminated film
- PF:: Protective film
- R1, R2, R3:: Glass roll
- T:: Target

## Claims

1. A glass film conveying device that continuously conveys a long glass film in vacuum or under reduced pressure, comprising:
a feeding unit that feeds a glass film from a roll on which the glass film is wound;
a glass film conveying unit that conveys the glass film fed by said feeding unit; and
a take-up unit that takes up the glass film conveyed by said glass film conveying unit in a roll shape while laminating the glass film and a long protective film having the substantially same width as the glass film and containing a volatile component, wherein
said take-up unit increases a temperature of the protective film and thereby vaporizes the volatile component.

2. The glass film conveying device according to claim 1, wherein
said take-up unit comprises:
a laminating roller that laminates the glass film and the protective film; and
a heating mechanism that heats said laminating roller in such a manner that a surface temperature of said laminating roller becomes a higher temperature than the temperature of the protective film.

3. The glass film conveying device according to claim 1, wherein
said take-up unit comprises a laminating roller that laminates the glass film and the protective film, and
said take-up unit increases the temperature of the protective film by abutting the glass film having a higher temperature than the protective film with the protective film in said laminating roller.

4. The glass film conveying device according to claim 1, wherein
said take-up unit comprises a laminating roller that laminates the glass film and the protective film, and
tension in the conveying direction applied to the protective film is larger than tension in the conveying direction applied to the glass film in said laminating roller.

5. The glass film conveying device according to claim 1, wherein
said take-up unit comprises a laminating roller that laminates the glass film and the protective film, and
the glass film is laminated on the protective film in a rotation range of 45 degrees or more from a position where take-up of the protective film on said laminating roller is started.

6. The glass film conveying device according to claim 1, wherein
said feeding unit separates the protective film from the roll on which the glass film is wound in a state where the glass film and the long protective film having the substantially same width as the glass film are laminated, and feeds the glass film.

7. The glass film conveying device according to claim 6, wherein
said glass film conveying unit conveys the glass film fed from said feeding unit and separated from the protective film, and
said take-up unit takes up the glass film conveyed by said glass film conveying unit in a roll shape while laminating the glass film and the protective film separated from the glass film in said feeding unit and conveyed to said take-up unit.

8. The glass film conveying device according to claim 1, wherein
the volatile component includes water content.
